Europäisches Patentamt

European Patent Office

Office européen des brevets

(11) Veröffentlichungsnummer: **0 394 661**
**A1**

(12) **EUROPÄISCHE PATENTANMELDUNG**

(21) Anmeldenummer: **90104991.6**

(22) Anmeldetag: **16.03.90**

(51) Int. Cl.5: **C23C 14/34, C23C 16/50, C23C 14/32**

(30) Priorität: **26.04.89 CH 1586/89**

(43) Veröffentlichungstag der Anmeldung:
**31.10.90 Patentblatt 90/44**

(84) Benannte Vertragsstaaten:
**AT BE CH DE ES FR GB IT LI LU NL SE**

(71) Anmelder: **BALZERS AKTIENGESELLSCHAFT**

**FL-9496 Balzers(LI)**

(72) Erfinder: **Bergmann, Erich, Dr.**
**Sarganserstrasse 58**
**CH-8887 Mels(CH)**
Erfinder: **Gassner, Franz**
**Mühle 47a**
**L-9497 Triesenberg(LI)**

(74) Vertreter: **Keller, René, Dr. et al**
**Patentanwälte Dr. René Keller & Partner**
**Postfach 12**
**CH-3000 Bern 7(CH)**

(54) **Verfahren zur wenigstens teilweisen Beschichtung von Werkstücken mittels eines sputter-CVD-Verfahens.**

(57) Die Werkstückoberfläche (57) wird mit einer mittels eines Sputter - CVD -Verfahrens aufgebrachten Schicht versehen, wobei deren optimale Härte und Gleitfähigkeit bei einer positiven Vorspannung der Werkstückoberfläche (57) gegenüber dem Plasma erreicht wird. Bei einer Wolframkarbid-Kohlenstoffschicht ist ein Optimum der Schichtqualität bei einer Vorspannung von fünfunddreißig Volt erzielbar. Neben Wolframkarbid-Kohlenstoffschichten lassen sich auch Silizid-Siliziumschichten erzeugen, sofern als reaktives Gas flüchtige Siliziumverbindungen verwendet werden.

EP 0 394 661 A1

## Verfahren zur wenigstens teilweisen Beschichtung von Werkstücken mittels eines Sputter-CVD-Verfahrens

Die Erfindung betrifft ein Verfahren zur wenigstens teilweisen Beschichtung von Werkstücken mittels eines Sputter-CVD-Verfahrens gemäß dem Oberbegriff des Patentanspruchs 1, sowie ein Werkstück beschichtet nach dem Verfahren gemäß dem Oberbegriff des Patentanspruchs 11.

Ein Verfahren dieser Art ist von C.E. Wickersham, E.L. Foster und G.H. Stickford in "Reactively sputter-deposited high-emissivity tungsten carbide/carbon coatings", J. Vac. Sci., Technol., 18(2), March 1981, Seite 223 bis 225 beschrieben. Hier wird ein Werkstück mit einer Wolfram-Karbid-Kohlenstoff-Schicht beschichtet. Die Kathodenzerstäubung (Sputtering) arbeitet dabei mit einer Frequenz von 13,56 MHz bei einer Leistung von 500 W und einer negativen Vorspannung der Werkstücke von 2800 V. Als reaktives Gas (CVD) wird Azetylen verwendet. Gleichartige Sputter-CVD-Verfahren sind aus der FA-A 2 543 737, EP-A 0 306 612 und US-A 4 414 085 bekannt, bei denen die Kathodenzerstäubung ebenfalls mit Hochfrequenz erfolgt und die Werkstücke negativ vorgespannt werden.

Das Verfahren der eingangs genannten Art (Sputter-CVD-Verfahren) ist einerseits zu unterscheiden von anderen plasmaunterstützten Chemical Vapour Deposition (CVD) Verfahren, bei denen die chemischen Reaktanden der die Schicht bildenden Substanz in Gasform in die Vakuumkammer eingeführt und im Raum vor den zu beschichtenden Werkstückoberflächen durch eine elektrische Gasentladung (Niedervoltbogen) aktiviert und teilweise ionisiert werden (CH-PS 664 768), wobei die Werkstücke auf eine negative Spannung gegenüber der Vakuumkammer und dem Bogenplasma gelegt werden. Im Gegensatz zum eingangs genannten Verfahren erfolgt dabei keine Kathodenzerstäubung.

Das gattungsgemäße Sputter-CVD-Verfahren ist andererseits zu unterscheiden von den Physical Vapour Deposition (PVD) Verfahren, bei denen die Substanzen ohne chemische Reaktion nur durch Kondensation von Dampf auf der Werkstückoberfläche aufgebracht werden. Dabei lässt sich der Dampf durch Kathodenzerstäubung erzeugen, vgl. z.B. von J.L. Vossen, J.J. Cuomo, in "Thin Film Processes", Academic Press, 1978, S. 56/57. Wie dort beschrieben wird entweder mit Gleichspannungs- oder Hochfrequenzglimmentladung gearbeitet und die Werkstücke werden an eine negative elektrische Vorspannung gelegt. Eine positive Vorspannung ist, wie Vossen et al. ausführen, aus mehreren Gründen zu vermeiden, namentlich deswegen, weil ein starker Elektronenfluß auf die Werkstücke einsetzt mit der Folge einer starken Substraterhitzung und einer sehr ungleichmäßigen Stromverteilung.

Das bekannte Verfahren der eingangs genannten Art ist zwar gegenüber den erwähnten Verfahren anderer Art hinsichtlich der Schichtzusammensetzung und Schichteigenschaften vorteilhaft. Die Anregung des Gases mittels einer Hochfrequenzspannung bedingt gegenüber einer mit Gleichspannung arbeitenden Anlage aber hohe Maschineninvestitionen wegen der notwendigen, leistungsstarken und den gesetzlichen Vorschriften entsprechend abgeschirmten HF-Generatoren. Ferner ist es schwierig, die Hochfre quenz ohne große Verluste in die Vakuumbeschichtungskammer einzuführen, besonders wenn die zu beschichtenden Teile während der Beschichtung von rotierenden Trägern gehalten sind.

Der Erfindung liegt die Aufgabe zugrunde, ein einfach durchzuführendes Verfahren der eingangs genannten Art zu schaffen, bei dem auf einer Werkstückoberfläche mit einem Sputter-CVD-Verfahren Schichten auf gebracht werden, welche eine hohe Härte und einen hohen Dreikörperabrasionswiderstand aufweisen.

Die erfindungsgemäße Lösung dieser Aufgabe ist hinsichtlich des Verfahrens Gegenstand der Patentansprüche 1 und 2 und hinsichtlich des Werkstücks Gegenstand des Patentanspruchs 11.

Gegenstand der Ansprüche 3 bis 10 sind bevorzugte Ausführungsformen des erfindungsgemäßen Verfahrens und Gegenstand der Ansprüche 12 bis 16 bevorzugte Ausführungsformen des Werkstücks.

Der durch die Erfindung erzielte Vorteil ist im wesentlichen darin zu sehen, daß es sich bei dem erfindungsgemäßen Verfahren um ein einfaches, ohne Verwendung von Hochfrequenz (und deshalb ohne amtliches Genehmigungsverfahren und ohne besondere Sicherungsmaßnahmen für den HF-Betrieb) durchführbares, preisgünstiges Sputter-CVD-Verfahren handelt, mit dem Schichten hoher Härte und eines hohen Dreikörperabrasionswiderstands erzielt werden.

Die (einzige) Figur zeigt ein Beispiel einer Einrichtung zur Durchführung des erfindungsgemäßen Verfahrens, bei dem auf dem Boden 1 einer Vakuumbeschichtungskammer 2 nebeneinander eine Vorrichtung 3 (selbstverständlich können auch mehrere angeordnet werden) zum magnetfeldunterstützen Sputterverfahren und eine Vorrichtung 4 zur Ionenplattierung (auch hier können mehrere vorhanden sein) angeordnet sind.

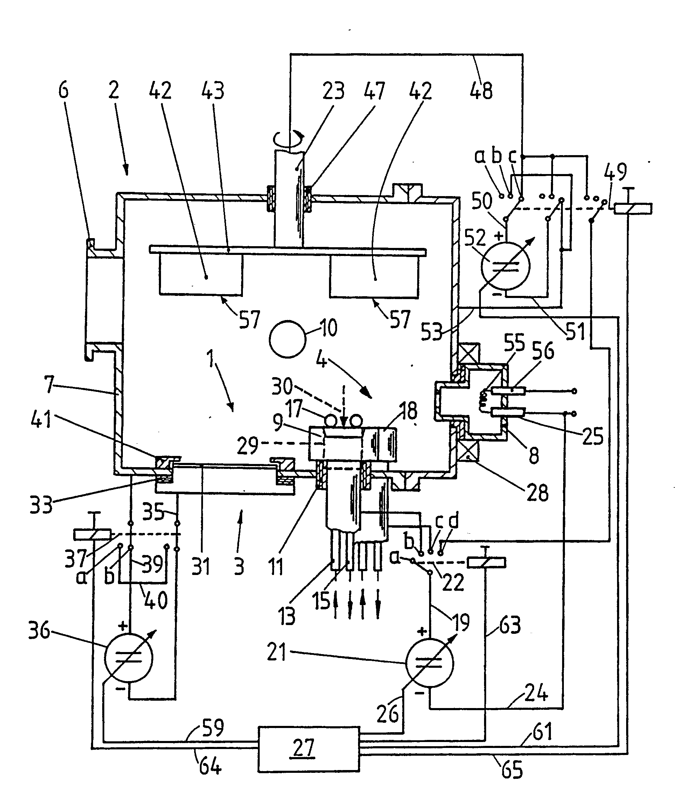

Die Vakuumbeschichtungskammer ist als rechteckige Kammer 2 ausgebildet, die über einen nicht dargestellten Pumpstand, der an einen Flansch 6 der Kammer 2 anschließbar ist, evakuierbar ist. An einer Wand 7 der Kammer 2 ist eine Ionisationskammer 8 für eine sog. Niedervoltbogenentladung angeflanscht und an der Rückwand befindet sich ein Gaseinlaß 10. Als Anode für die Niedervoltbogenentladung zur Ionenplattierung dient ein Verdampfungstiegel 9, der von der Kammer 2 durch eine Isolationshülse 11 aus Isoliermaterial elektrisch getrennt ist, und mittels eines Wärmetauschers, dessen Kühlwasserein- und -auslaß 13 und 15 in der Figur dargestellt sind, gekühlt wird. Im Verdampfungstiegel 9 liegt ein verdampfbares Material 17. Eine gekühlte Kupferplatte 18 als Hilfsanode mit einem zum Verdampfungstiegel 9 analogen Wärmetauscher liegt in der Zeichnung hinter dem Verdampfungstiegel 9. Der positive Pol 19 eines Bogenentladungsspeisegeräts 21 ist über einen Schalter 22 elektrisch entweder mit dem Verdampfungstiegel 9 (Schalterposition 22b), der Hilfsanode 18 (Schalterposition 22c) oder mit einer unten beschriebenen Drehachse 23 (Schalterposition 22d) über einen Schalter 49 (Schalterposition 49a) verbindbar. Durch den Schalter 22 ist der positive Pol 19 in einer Schalterposition 22a vollständig abschaltbar. Der negative Pol 24 des Bogenentladungsspeisegeräts 21 ist mit einer Elektrode 25 in der Ionisationskammer 8 verbunden. Spannung und abgebbarer Strom des Bogenentladungsgeräts 21 sind einstellbar und werden über eine Steuerleitung 26 von einer Steuereinrichtung 27 eingestellt. Zur Fokussierung und Führung des Niedervoltbogens dient das Magnetfeld einer oder mehrerer schematisch dargestellter Spulen 28. Die Technik der Materialverdampfung, sowie die Führung und Fokussierung des Niedervoltbogens sind Stand der Technik und können einschlägiger Literatur entnommen werden.

In der Figur ist zwischen dem Verdampfungstiegel 9 am Boden 1 und der Hilfsanode 18 eine sog. Fernfokus-Elektronenquelle 29 angeordnet. Durch ein nicht dargestelltes Magnetfeld, dessen Feldlinien im wesentlichen senkrecht zur Zeichenebene verlaufen, ist ein Elektronenstrahl 30 der Quelle 29 auf das zu verdampfende Material 17 lenkbar. Die Elektronen werden auf ihrem Weg von der Quelle 29 zum Material 17 um 180° abgelenkt und gleichzeitig fokussiert.

In der Figur links neben dem Verdampfungstiegel 9 ist am Boden 1 die Vorrichtung 3 zum magnetfeldunterstützten Sputtern, wie bereits oben erwähnt, angeordnet. Sie ist mit einem nicht dargestellten Wärmetauscher zur Kühlung versehen. Das erforderliche Magnetsystem ist ebenfalls, um die Figur nicht zu überladen, nicht dargestellt; sein Aussehen und seine Lage können ebenfalls der einschlägigen Literatur entnommen werden. An der Innenseite der Kammer 2 hat die Vorrichtung 3 als Kathode ein Target 31 aus Wolframkarbid, welches während des Sputterns zerstäubt wird. Das Target 31 ist von der Wand 7 der Kammer 2 durch einen isolierenden Ring 33 elektrisch isoliert und mit dem negativen Pol 35 einer Spannungsquelle 36 über einen zweipoligen Wechselschalter 37 verbunden. Der positive Pol 39 der Spannungsquelle 36 liegt über dem anderen Zweig des Wechselschalters 37 elektrisch an der Wand 7 der Kammer 2, welche mit einer vom Rand des Zerstäubungstargets 31 distanzierten Anode 41 leitend verbunden ist. Der Wechselschalter 37 hat zwei Posititonen, wobei die eben beschriebene mit 37b und eine weitere, in der das Target 31 mit der Wand 7, und so mit der Anode 41 über einen elektrischen Kurzschluß 40 verbindbar ist, mit 37a bezeichnet ist. Das Plasma der Entladung wird beim Sputtern durch die Anode 41 begrenzt.

Zwei von mehreren (z. B. sieben) zu beschichtenden Werkstücken 42 sind in der Zeichnung dargestellt und auf einem Drehteller 43 in der Kammer 2 befestigt. Der Drehteller 43 ist an der Drehachse 23, welche durch ein Zwischenstück 47 von der Wand 7 isoliert gelagert und durch einen nicht dargestellten Antrieb in Rotation versetzbar ist, elektrisch leitend befestigt. Die Drehachse 23 und damit auch die Werkstücke 42 sind mit einer Leitung 48 über den Schalter 49 sowohl mit dem positiven Pol 50 wie auch mit dem negativen 51 einer Spannungsquelle 52, sowie mit dem positiven Pol 19 über den Schalter 22 (Schalterposition 22d) des Bogenentladungsspeisegeräts 21 verbindbar. Über den Schalter 49 ist die Spannungsquelle 52 sowohl mit ihrem positiven Pol 50 (Schalterposition 49b) als auch mit ihrem negativen Pol 51 (Schalterposition 49c) mit der Wand 7 über eine Leitung 53 elektrisch leitend verbindbar. Das Potential der Wand 7 beträgt null Volt.

In der Ionisationskammer 8 verbindet eine Wendel 55 aus einer geeigneten refraktären Legierung, z. B. Wolfram oder Tantal, die Elektrode 25 mit einer weiteren gegenüber der Wand der Ionisationskammer 8 und der Elektrode 25 isolierten Elektrode 56. Ein Netzgerät zur Stromversorgung der Wendel 55 ist nicht dargestellt.

Die den Vorrichtungen 3 und 4 zum Sputtern und Ionenplattieren zugewandte Oberfläche der Werkstücke 42 ist mit 57 bezeichnet. Der Abstand der zu beschichtenden Werkstückoberflächen 57 vom Verdampfungstiegel 9 ist so groß gewählt, daß die zwischen diesem und der Wendel 55 bzw. der Elektrode 25 durch den brennenden Niedervoltbogen hervorgerufene elektrische Ionisation bezogen auf die Ionisation des Bogenkerns unter zwanzig Prozent abgefallen ist.

Die Spannung bzw. der zu liefernde Strom der Spannungsquellen 36 und 52 ist von der Steuereinrichtung 27 durch je eine Steuerleitung 59 bzw. 61 einstell- und kontrollierbar. Die Schalter 22, 37 und 49 sind ebenfalls durch je eine Steuerleitung 63, 64 bzw. 65 zur Steuereinrichtung 27 von dieser schaltbar und die Schalterposition überprüfbar.

Die in der Zeichnung dargestellten Schalter 22, 37 und 49 befinden sich in den Schalterpositionen, welche sie beim letzten Prozeßschritt zum Aufbringen einer Wolframkarbid-Kohlenstoffschicht haben.

Zur Beschichtung werden die Werkstücke 42 am Drehteller 43 leitend befestigt und die Kammer 2 durch eine nicht dargestellte Gaseinlaßvorrichtung, deren Gaseinlaß 10 in der Figur dargestellt ist, mit Argon gefüllt. Der Wechselschalter 37 befindet sich in der Schalterposition 37a, wodurch das Target 31 mit der Wand 7 elektrisch leitend verbunden ist. Um die Werkstücke 42 aufzuheizen, brennt ein Niedervoltbogen von der Wendel 55 zu den Oberflächen 57 der Werkstücke 42. Hierzu ist der Schalter 49 in der Schalterposition 49a und der Schalter 22 in der Position 22d, wodurch der positive Pol 19 der Spannungsquelle 21 mit den Werkstücken 42 verbunden ist.

Nach ausreichender Aufheizung der Werkstückoberflächen 57 wird der Schalter 22 in die Schalterposition 22c geschaltet, wodurch der positive Pol 19 der Spannungsquelle 21 mit der Hilfsanode 18 verbunden wird, damit der Niedervoltbogen zwischen der Hilfsanode 18 und der Wendel 55 brennt. Der Strom des Niedervoltbogens wird gleichzeitig von der Steuereinrichtung 27 durch ein Signal über die Steuerleitung 26 an die Spannungsquelle 21 verkleinert. Der Schalter 49 wird von der Steuereinrichtung 27 über die Steuerleitung 65 in die Schalterposition 49b gebracht. Durch diesen Schaltvorgang liegen die Werkstücke 42 am negativen Pol 51 der Spannungsquelle 52; die Wand 7 liegt am positiven Pol 50 der Spannungsquelle 52. Aufgrund des negativen Potentials der Werkstückoberfläche 57 werden durch den Niedervoltbogen erzeugte Argonionen von den Werkstückoberflächen 57 angezogen und schlagen aus dieser aufgrund ihrer kinetischen Energie an der Oberfläche 57 liegendes Material heraus. Dieses Herausschlagen ergibt einen Reinigungseffekt der Oberfläche 57.

Ist die Oberfläche 57 ausreichend gereinigt, so wird der Schalter 22 in die Position 22b gebracht, in der der positive Pol 19 der Spannungsquelle 21 mit dem Verdampfungstiegel 9 verbunden ist. Aufgrund dieser Umschaltung brennt nun der Niedervoltbogen zwischen der Elektrode 25 bzw. der Wendel 55 und dem Verdampfungstiegel 9. Als zu verdampfendes Material 17 wird Titan verwendet. Gleichzeitig mit dem Umschalten des Niedervoltbogens wird die Elektronenquelle 29 eingeschaltet und ihr Elektronenstrahl 30 auf das Titan 17 mittels der nicht dargestellten Ablenk- und Fokussiermagnete gelenkt und fokussiert. Der Strom des Niedervoltbogens wird auf ungefähr 110 Ampere eingestellt. Die Elektronen des Elektronenstrahls 30 werden mit 6 bis 10 kV beschleunigt, wobei die maximale Leistung 14 kW beträgt. Infolge der mit dem fokussierten Elektronenstrahl 30 erzielten Leistungsdichte beim Aufprall der Elektronen auf das im Verdampfungstiegel 9 befindliche Titan 17, wird dieses örtlich sehr hoch erhitzt, so daß eine hohe Verdampfungsrate resultiert. Der Dampf wird durch den Niedervoltbogen ionisiert. Das verdampfte und ionisierte Titan schlägt sich als sog. Haftschicht für noch aufzubringende weitere Schichten auf den Werkstückoberflächen 57 nieder (sog. Ionenplattierverfahren).

Damit die Ablagerung gleichmäßig erfolgt, dreht sich der Drehteller 43 mit einer Umdrehungszahl von etwa drei Umdrehungen pro Minute.

Hat die aufgebrachte Schicht eine Dicke von 0,1 bis 0,2 Mikrometer erreicht, wird durch den Wechselschalter 37 der Kurzschluß 40, der die Vorrichtung 3 zum Sputtern mit der Wand 7 verbindet, aufgehoben, indem der Wechselschalter 37 in die Schalterposition 37b von der Steuereinrichtung 27 über die Steuerleitung 64 geschaltet wird. Hierdurch ist der negative Pol 35 der Spannungsquelle 36 an das Wolframkarbid als Zerstäubungstarget 31 gelegt. Der Vorgang des Sputterns wird in Gang gesetzt. Spannung und Strom der Spannungsquelle 36 wird durch die Steuerleitung 59 von der Steuereinrichtung 27 eingestellt und kontrolliert. Annähernd gleichzeitig mit dem Wechselschalter 37 wird der Schalter 49 in die Schalterposition 49a gebracht. An den Werkstücken 42 liegt somit weder eine positive noch eine negative Spannung; sie sind erdfrei (floating). Wolfram und Wolframkarbid werden vom Target 31 abgestäubt und aus dem Azetylen mittels der plasmachemischen Reaktion Kohlenstoff abgeschieden. Es entsteht auf der Werkstückoberfläche 57 eine Mischschicht aus dem mittels Elektronenstrahl 30 verdampftem und durch den Niedervoltbogen ionisiertem Titan als Ionenplattierung mit dem zerstäubten Wolfram-Karbid-Kohlenstoff, wobei durch eine plasmachemische Reaktion aus dem Azetylengas Kohlenstoff erzeugt wird, der sich teilweise mit dem Wolfram zu Karbid vereinigend ebenfalls auf den Werkstücken 42 neben Titan und Kohlenstoff niederschlägt. Damit die Ablagerung gleichmäßig erfolgt, dreht sich der Drehteller 43 mit den Werkstücken 42 mit einer Umdrehungszahl von etwa zwölf Umdrehungen pro Minute.

Beträgt die Mischschichtdicke einige zehn Nanometer, wird der Elektronenstrahl 30 und der Niedervoltbogen ausgeschaltet. Der positive Pol 50 der Spannungsquelle 52 wird über den Schalter 49 (Schalterposition 49c) an die Werkstücke 42 über die Leitung 48 und der negative Pol 51 an die Wand 7 gelegt. Der Schalter 22 wird in die Position 22d gesetzt, wodurch der Niedervoltbogen erlischt. Die Spannung für die Werkstücke 42 wird über die Steuerleitung 61 von der Steuereinrichtung 27 von der Spannungsquelle 52 auf dreißig Volt geregelt. Hierdurch werden die Werk stückoberflächen 57 während des nachfolgend beschriebenen Sputtervorganges gegenüber dem Plasma der Zerstäu- bung auf einem positiveren Gleichspannungspoten- tial gehalten. Als Potential des Plasmas (flaoting Potential) gilt bekanntlich jene Spannung, welche mit einem nicht dargestellten, hochohmigen Voltmeter, dessen einer Pol mit der Wand 7 (Masse) der Kammer 2 und dessen anderer Pol mit der Leitung 48 verbunden ist, gemessen wird, wenn die Werkstücke 42 über die Leitung 48 weder mit dem Bogenentladungsspeisegerät 21 noch mit der Spannungsquelle 52 verbunden sind (Schalterstellungen 49a und 22a). Durch die nicht dargestellte Gaseinlaßvorrichtung wird über den Gaseinlaß 10 Azetylen als reaktives Gas für eine plasmachemische Reakton mit einem Gasfluß vom etwa 350 Standardkubikzentimeter pro Minute bei sieben zu beschichtenden Werkstücken 42 eingelassen; der genaue Gasfluß richtet sich nach der Anzahl Werkstücke 42 und deren zu beschichtende Flächenausmaße. Der Gasdruck des Azetylens in der Kammer 2 beträgt etwa 1 Pa. Wolfram und Wolframkarbid aus dem Zerstäubungstarget 31, sowie Kohlenstoff, welcher durch die plasmachemische Reaktion aus dem Azetylen herausgelöst wird und sich teilweise mit dem Wolfram zu Wolframkarbid vereinigt, schlagen sich auf den Werkstückoberflächen 57 nieder. Es wird zerstäubt (gesputtert) bis eine Schichtdicke aus Wolframkarbid/Kohlenstoff von einigen Mikrometern erreicht ist. Während des Zerstäubens wird von der Spannungsquelle 52 der zu liefernde Strom auf dem 1,2 fachen Wert des Stroms in der Kathodenleitung 35 gehalten.

Überraschenderweise hat sich gezeigt, daß ohne Verwendung von Hochfrequenz beim Sput- tern mittels einer Gleichspannungskathodenzer- stäubung, bei der die zu beschichtenden Werkstük- ke 42 auf einer positiven Spannung liegen, sehr gut haltende Wolframkarbid-Kohlenstoffschichten hoher Härte und mit einem hohen Dreikörperabrasionswiderstand erzeugbar sind. Ein Optimum der Schichtqualität wird erreicht bei einer positiven Vorspannung von annähernd fünfunddreißig Volt. Bei dieser Spannung ist der Strom in der Leitung 48 um annähernd zwanzig Prozent höher als der Strom in der Leitung 35.

Anstelle Wolfram (Wolfram-Wolframkarbid) als zu zerstäubendem Material, können auch Bor, Kohlenstoff, Silizium, Metalle der chemischen Gruppen IVb, Vb, Vlb, VIII, oder deren Legierungen mit einem wesentlichen Anteil einer dieser Elemente, oder Verbindungen dieser Elemente miteinander oder Metalloide der Gruppen IVa, Va, VIa als Kathodenmaterial verwendet werden.

Die nach obigem Verfahren hergestellten Schichten besitzen fünfzig bis neunundneunzig Atomprozent freien Kohlenstoff und einen Rest, der im wesentlichen Karbide der Elemente Bor, Silizium oder der Elemente der Gruppen IVb, Vb, Vlb, VIII oder deren Mischungen enthält.

Anstelle Azetylen als Kohlenstoff abspaltendes Gas zu verwenden, können auch andere Gase, die eine wesentliche Kohlenwasserstoffkomponente besitzen, verwendet werden. Auch können anstelle von Kohlenstoff liefernden Gasen oder Gasgemischen, Gase oder Gasgemische mit flüchtigen Siliziumverbindungen zur Herstellung von Silizid-Siliziumschichten verwendet werden.

Anstelle des zum Verdampfungstiegel 9 brennenden Niedervoltbogens, können auch in einer horizontalen Ebene unterhalb des Drehtellers 43 zwei Elektroden angeordnet sein, zwischen denen ein Niedervoltbogen zur Ionisation des aus dem Tiegel verdampften Materials brennt.

Die Schicht kann auch aus mehreren Schicht lagen aus unterschiedlichem Material aufgebaut sein. Auch kann eine der Schichtlagen in reaktiver und eine der anderen in nicht reaktiver Atmosphäre aufgebracht werden.

Bei gewissen Werkstückmaterialien, wie z. B. Titanlegierungen und gewissen Stählen, kann auf die Haft- und Mischschicht verzichtet werden. In diesem Fall entfällt in der Kammer 2 der Verdampfungstiegel 9, die Hilfsanode 18, die Ionisationskammer 8 und die Fernfokus-Elektronenquelle 29, sowie das Bogenentladungsspeisegerät 21. Die Reinigung der Werkstück oberflächen 57 kann dann, wie nach dem Stand der Technik bekannt, mit einem anderen als dem beschriebenen Verfahren durchgeführt werden.

Anstelle die Werkstückoberflächen 57 auf ein Gleichspannungspotential von dreißig Volt gegenüber der Anode zu legen, kann auch das Potential des Plasmas der Zerstäubung am Ort der Werkstücke 42 experimentell bestimmt werden und dann während des Sputterns die Spannung der Spannungsquelle 52 so eingestellt werden, daß die Werkstückoberflächen 57 auf einem gegenüber dem Plasma um fünfundzwanzig bis fünfundvierzig Volt positiveren Gleichspannungspotention gehalten werden.

**Ansprüche**

1. Verfahren zur wenigstens teilweisen Beschichtung von Werkstücken (42) mittels eines Sputter-CVD-Verfahrens in einer Vakuumbeschichtungskammer (2), wobei mindestens ein Material (31) als Kathode zerstäubt und mit mindestens einer Komponente eines durch plasmachemische Reaktion zerlegten Gases oder Gasgemisches wenigstens teilweise zur Reaktion gebracht wird, dadurch gekennzeichnet, daß die zu beschichtenden Werkstückoberflächen (57) auf einem gegenüber dem Plasma der Zerstäubung positiveren Gleichspannungspotential gehalten werden und die Zerstäubung mit einer Gleichspannung zwischen dem zu zerstäubenden Material (31) und einer Anode (41) betrieben wird.

2. Verfahren zur wenigstens teilweisen Beschichtung von Werkstücken (42) mittels eines Sputter-CVD-Verfahrens in einer Vakuumbeschichtungskammer (2), wobei mindestens ein Material (31) als Kathode zerstäubt und mit mindestens einer Komponente eines durch plasmachemische Reaktion zerlegten Gases oder Gasgemisches wenigstens teilweise zur Reaktion gebracht wird, dadurch gekennzeichnet, daß die zu beschichtenden Werkstückoberflächen (57) auf einem gegenüber der Anode (41) der Vorrichtung (3) zum Sputtern positiveren Gleichspannungspotential gehalten und die Zerstäubung mit einer Gleichspannung zwischen dem zu zerstäubenden Material (31) und der Anode (41), sowie den Werkstücken (42) betrieben wird.

3. Verfahren nach Anspruch 1, dadurch gekennzeichnet, daß die Werkstückoberflächen (57) auf einem gegenüber dem Plasma um fünfundzwanzig bis fünfundvierzig Volt positiveren Gleichspannungspotential gehalten werden.

4. Verfahren nach Anspruch 2, dadurch gekennzeichnet, daß die Werkstückoberflächen (57) auf einem gegenüber der Anode (7) um zwanzig bis vierzig Volt positiveren Gleichspannungspotential gehalten werden.

5. Verfahren nach einem der Ansprüche 1 bis 4, dadurch gekennzeichnet, daß den Werkstücken (42) ein Strom von mindestens fünfzig Prozent des durch die Kathodenzuleitung (35) zum zu zerstäubenden Material (31) fließenden Stroms zugeführt wird.

6. Verfahren nach Anspruch 5, dadurch gekennzeichnet, daß der den Werkstücken zugeführte Strom auf einen zwischen dem einfachen und eineinhalbfachen, insbesondere 1,2-fachen Wert des Stroms in der Kathodenzuleitung (35) eingestellt wird.

7. Verfahren nach einem der Ansprüche 1 bis 6, dadurch gekennzeichnet, daß Metalle der Gruppen IVb, Vb, VIb, VIII, Bor, Kohlenstoff, Silizium oder Legierungen mit einem wesentlichen Anteil dieser Elemente, oder Verbindungen dieser Elemente untereinander oder mit den Metalloiden der Gruppen IVa, Va, VIa als zu zerstäubendes Material (31) verwendet werden.

8. Verfahren nach einem der Ansprüche 1 bis 7, dadurch gekennzeichnet, daß das Gas oder Gasgemisch mindestens einen Kohlenwasserstoff als wesentliche Komponente enthält.

9. Verfahren nach einem der Ansprüche 1 bis 7, dadurch gekennzeichnet, daß das Gas oder Gasgemisch mindestens eine flüchtige Siliziumverbindung als wesentliche Komponente enthält, um insbesondere Silizid-Siliziumschichten herstellen zu können.

10. Verfahren nach einem der Ansprüche 1 bis 9, dadurch gekennzeichnet, daß vor dem Zerstäuben mit der Gleichspannung in die Vakuumbeschichtungskammer (2) ein ionisierbares neutrales Gas, insbesondere Argon, eingelassen wird und die Werkstückoberflächen (57) an ein negatives Potential gegenüber den Wänden (7) der Beschichtungskammer (2) gelegt werden, sowie mittels eines Elektronenstrahls (30) aus einem Verdampfungstiegel (9) ein weiteres Material (17), vorzugsweise Titan, derart verdampft und mit einem Niedervoltbogen ionisiert wird, daß es sich als ionenplattierte Schicht, insbesondere als Haftschicht für nachfolgend aufzubringende Materialien, mit einer Dicke von 0,1 bis 0,2 Mikrometern auf den Werkstückoberflächen (57) niederschlägt, und anschließend unter weiterem Verdampfen das negative Potential der Werkstücke (57) aufgehoben wird, wodurch sie erdfrei werden und das durch die plasmachemische Reaktion zerlegbare Gas oder Gasgemisch eingelassen wird und zusätzlich das erste Material (31) zerstäubt wird, bis eine weitere Schicht mit einer Dicke von einigen zehn Nanometern erreicht ist.

11. Werkstück beschichtet nach dem Verfahren gemäß einem der Ansprüche 1 bis 10, gekennzeichnet durch eine mittels Sputter-CVD-Verfahren erzeugte Schicht.

12. Werkstück nach Anspruch 11, dadurch gekennzeichnet, daß unmittelbar auf der Werkstückoberfläche (57) eine ionenplattierte Schicht, darüber eine Mischschicht aus dem ionenplattierten Material und einem mittels Sputter-CVD-Verfahren zerstäubten Material und über der Mischschicht eine nur mittels Sputter-CVD-Verfahren erzeugte Schicht liegt.

13. Werkstück nach Anspruch 11 oder 12, dadurch gekennzeichnet, daß die mittels Sputter-CVD-Verfahren erzeugte Schicht eine Metall-Karbid-Kohlenstoff-Schicht ist.

14. Werkstück nach Anspruch 11 oder 12, dadurch gekennzeichnet, daß die mittels Sputter-CVD-Verfahren erzeugte Schicht aus fünfzig bis neunundneunzig Atomprozent freiem Kohlenstoff und einem im wesentlichen aus Karbiden der Elemente Bor, Silizium, oder der Elemente der Gruppen IVb, Vb, VIb, VIII, oder deren Mischungen gebildeten Rest besteht.

15. Werkstück nach Abspruch 11 oder 12, dadurch gekennzeichnet, daß die mittels Sputter-CVD-Verfahren erzeugte Schicht Wolframkarbid-Kohlenstoff enthält.

16. Werkstück nach Anspruch 11 oder 12, dadurch gekennzeichnet, daß die mittels Sputter-CVD-Verfahren erzeugte Schicht eine Silizid-Siliziumschicht ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | FR-A-2 543 737 (DIRECTOR GENERAL OF AGENCY OF INDUSTRIAL SCIENCE OF TECHNOLOGY) <br> * Seite 7, Zeilen 27-35; Seite 8, Zeile 33 - Seite 9, Zeile 7 * <br> --- | 1,2,3, 11 | C 23 C 14/34 <br> C 23 C 16/50 <br> C 23 C 14/32 |
| A,D | EP-A-0 306 612 (BALZERS AG) <br> * Zusammenfassung; Abbildungen * <br> --- | 10 | |
| A,D | US-A-4 414 085 (WICKERSHAM et al.) <br> * Ansprüche 1,2,5,6 * <br> ----- | 6,7,13-15 | |

| | | | RECHERCHIERTE SACHGEBIETE (Int. Cl.5) |
|---|---|---|---|
| | | | C 23 C |

Der vorliegende Recherchenbericht wurde für alle Patentansprüche erstellt

| Recherchenort | Abschlußdatum der Recherche | Prüfer |
|---|---|---|
| DEN HAAG | 06-08-1990 | PATTERSON A.M. |